# EUROPEAN PATENT APPLICATION

(11) **EP 2 413 371 A2**
(43) Date of publication of application: **01.02.2012**
(21) Application number: 11168297.7
(22) Date of filing: 31.05.2011
(51) Int. Cl.: H01L 31/0224, H01G 9/20

(54) **Electrode for photoelectric device, method of preparing the same and photoelectric device comprising the same**

(30) Priority: 29.07.2010 KR 20100073443
(71) Applicant: Samsung SDI Co., Ltd., Yongin-si, Gyeonggi-do (KR)
(72) Inventor: Yang, Nam-Choul, Gyeonggi-do (KR); Hur, Sang-Yeol, Gyeonggi-do (KR)
(74) Representative: Walaski, Jan Filip

(57) **Abstract**

An electrode for a photoelectric conversion device, a method of preparing the same and a photoelectric conversion device comprising the same. In one embodiment, an electrode for a photoelectric conversion device includes a transparent conductive layer, a metal electrode layer and a protection layer. The transparent conductive layer is formed on a substrate to have spacing regions formed at a set interval. The metal electrode layer is formed in a corresponding one of the spacing regions. The protection layer is formed on the transparent conductive layer and the metal electrode layer to coat the metal electrode layer. Accordingly, the shape of a protruded electrode is improved, thereby enhancing the reliability of products through a simple process.

## Description

The present invention relates to an electrode for a photoelectric device, a method of preparing the same and a photoelectric device comprising the same.

A solar cell is a desired energy source because solar energy is virtually unlimited and eco-friendly unlike other energy sources. Solar cells can be classified into silicon solar cells, dye solar cells, etc.

Silicon solar cells are difficult to be put to practical use because their fabrication costs are relatively high. Further, it is very difficult to improve the efficiency of the silicon solar cells.

On the other hand, dye solar cells are photoelectric chemical solar cells using a dye molecule and a transition metal oxide as main materials. Here, the dye molecule generates electron-hole pairs by absorbing visible light, and the transition metal oxide transfers the generated electrons. Since the dye solar cells have remarkably lower fabrication costs than existing silicon-based solar cells, it is possible to substitute them for existing amorphous silicon solar cells.

A metal electrode layer of the dye solar cell is formed to protrude from a transparent electrode on a substrate, and a protection layer for preventing (or protecting from) corrosion of the metal electrode layer is formed on a protruded portion of the metal electrode layer that is in a region which is filled with an electrolyte solution and sealed by a sealing material.

If the metal electrode layer is protruded from the substrate as described above, a difference in interfaces between regions occurs. In one region, the protruded metal electrode layer is formed, and the protection layer is also formed on the metal electrode layer. In another region, only the protruded metal electrode layer is formed, and the protection layer is not formed. Here, the protection layer is not formed on the lower surface of the sealing material, and the electrolyte solution may leak due to the decrease of adhesion of the sealing material or the looseness of the sealing material due to the protruded metal electrode layer itself. Therefore, there is a problem in view of the reliability of products.

An aspect of an embodiment of the present invention is directed toward an electrode for a photoelectric conversion device, a method of preparing the same and a photoelectric conversion device comprising the same, which can enhance the reliability of products by improving or enhancing the shape of a protruded electrode.

According to an aspect of the present invention, there is provided an electrode for a photoelectric device, the electrode including a transparent conductive layer formed on a substrate to have spacing regions formed at a set interval; a metal electrode layer formed in a corresponding one of the spacing regions; and a protection layer formed on the transparent conductive layer and the metal electrode layer to coat the metal electrode layer.

The substrate may have groove portions with a set pattern.

The positions of the groove portions may match the respective spacing regions.

The metal electrode layer may have a shape matching a corresponding one of the groove portions.

The cross-section of each of the groove portions in the thickness direction of the substrate may have a polygonal shape, a polygonal cone shape, an elliptic shape, or a circular shape.

A lower surface of the metal electrode layer may contact an upper surface of the substrate.

The height of an upper surface of the metal electrode layer may be between the height of the upper surface of the substrate and the height of an upper surface of the transparent conductive layer.

The protection layer may have a thickness at or between 10 and 50µm.

According to another aspect of the present invention, there is provided a method of preparing an electrode for a photoelectric device, the method including: providing a substrate having a transparent conductive layer formed thereon; patterning the transparent conductive layer to have spacing regions formed at a set interval; forming a metal electrode layer in a corresponding one of the spacing regions; and forming a protection layer on the transparent conductive layer and the metal electrode layer to coat the metal electrode layer.

The method may further include forming groove portions with a set pattern on the substrate before the forming of the metal electrode layer.

The positions of the groove portions may match the respective spacing regions.

The metal electrode layer may have a shape matching a corresponding one of the groove portions.

The cross-section of each of the groove portions in the thickness direction of the substrate may have a polygonal shape, a polygonal cone shape, an elliptic shape, or a circular shape.

In the forming of the metal electrode layer, a lower surface of the metal electrode layer may come in contact with an upper surface of the substrate.

In the forming of the metal electrode layer, the height of an upper surface of the metal electrode layer may be between the height of the upper surface of the substrate and the height of an upper surface of the transparent conductive layer.

In the forming of the protection layer, the protection layer may have a thickness at or between 10 and 50µm.

According to a further aspect of the present invention, there is provided a photoelectric device including: a first substrate; a first electrode on the first substrate; a photoelectrode layer on at least one surface of the first electrode, the photoelectrode layer including a photo-sensitizing dye; a second substrate; a second electrode on the second substrate and facing the first electrode; a counter-electrode layer on at least one surface of the second electrode, the counter-electrode layer including a conductive catalyst; a sealing member joining the first and second electrodes; and an electrolyte solution injected into a space between the first and second electrodes and sealed in the space between the first and second electrodes by the sealing member, wherein at least one of the first and second electrodes includes a transparent conductive layer formed on a corresponding one of the first and second substrates and having a plurality of spacing regions at a set interval, a metal electrode layer formed in a corresponding one of the spacing regions, and a protection layer formed on the transparent conductive layer and the metal electrode layer to coat the metal electrode layer.

As described above, according to the embodiments of the present invention, the shape of a protruded electrode is improved, so that the reliability of products can be enhanced through a simple process.

Also, as the metal electrode layer has a structure in which the step difference is reduced as described above, the leakage of the electrolyte solution due to the degradation of the adhesion of the sealing member or the looseness of the sealing member can be reduced, thereby enhancing the reliability of products.

Also, while three surfaces of the metal electrode layer were conventionally exposed, only the upper surface of the metal electrode layer is now exposed. Thus, it is possible to decrease the possibility of corrosion of the metal electrode layer, which may be caused by the crack or looseness of the protection layer.

The accompanying drawings, together with the specification, illustrate exemplary embodiments of the present invention, and, together with the description, serve to explain the principles of the present invention.
FIG. 1 is a sectional view schematically showing the entire configuration of a photoelectric conversion device according to an embodiment of the present invention.
FIG. 2 is a view schematically showing the state in which a dye is connected to an inorganic metal oxide semiconductor.
FIG. 3 is a plan view schematically showing a partial configuration of the photoelectric conversion device.
FIG. 4 is a sectional view schematically showing the structure of an electrode for the photoelectric conversion device according to a first embodiment of the present invention.
FIG. 5 is a sectional view schematically showing the structure of an electrode for the photoelectric conversion device according to a second embodiment of the present invention.
FIG. 6 is a sectional view schematically showing the structure of an electrode for the photoelectric conversion device according to a third embodiment of the present invention.
FIG. 7 is a sectional view schematically showing the structure of an electrode for the photoelectric conversion device according to a fourth embodiment of the present invention.

In the following detailed description, only certain exemplary embodiments of the present invention have been shown and described, simply by way of illustration. As those skilled in the art would realize, the described embodiments may be modified in various different ways, all without departing from the spirit or scope of the present invention. Accordingly, the drawings and description are to be regarded as illustrative in nature and not restrictive. In addition, when an element is referred to as being "on" another element, it can be directly on the another element or be indirectly on the another element with one or more intervening elements interposed therebetween. Also, when an element is referred to as being "connected to" another element, it can be directly connected to the another element or be indirectly connected to the another element with one or more intervening elements interposed therebetween. Hereinafter, like reference numerals refer to like elements.

The terminology used herein is for the purpose of describing particular embodiments only and is not intended to be limiting of this disclosure. As used herein, the singular forms "a", "an" and "the" are intended to include the plural forms as well, unless the context clearly indicates otherwise. It will be understood that the terms "comprises" and/or "comprising", or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

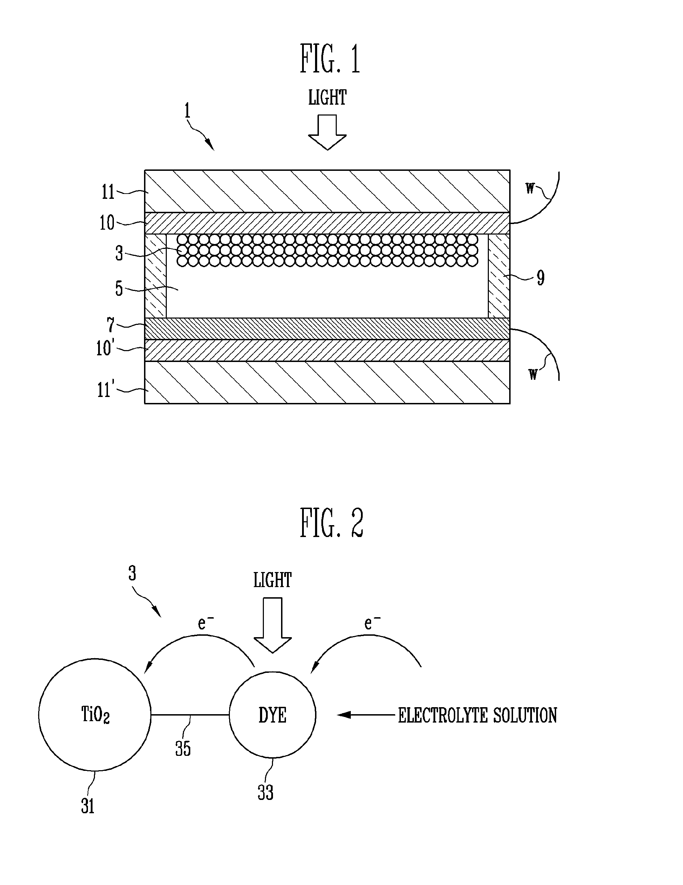

Hereinafter, an electrode for a photoelectric conversion device and a photoelectric conversion device comprising the same according to an embodiment of the present invention will be described in detail with reference to FIGS. 1 to 4.

Referring to FIGS. 1 and 2, a photoelectric conversion device 1, or photoelectric device, according to an embodiment of the present invention includes a first substrate 11, a second substrate 11', a first electrode 10, a second electrode 10', a photoelectrode layer 3, a counter-electrode layer 7, an electrolyte solution 5, a sealing member 9 and extracting wires W.

The first and second substrates 11 and 11' are disposed to oppose (or disposed to face) each other at a set or predetermined interval. The material of the first and second substrates 11 and 11' can be any suitable transparent material having a low light absorption with respect to a spectrum or range from a visible region to a near infrared region of light (e.g., sunlight or the like) incident from the exterior of the photoelectric conversion device 1.

For example, the material of the first and second substrates 11 and 11' may include a glass material such as quartz, general glass, crown glass (borosilicate glass or BK7) or lead glass; a resin material such as polyethylene terephthalate, polyethylene naphthalate, polyimide, polyester, polyethylene, polycarbonate, polyvinylbutyrate, polypropylene, tetraacetylcellulose, syndiotactic polystyrene, polyphenylenesulfide, polyarylate, polysulfone, polyestersulfone, polyetherimide, annular polyolefin, phenoxy bromide or vinyl chloride; or the like.

In the first and second substrates 11 and 11', a transparent conductive layer 13 formed into a film, for example, using a transparent conductive oxide (TCO) is formed on a surface of at least the first substrate 11 onto which external light is incident. The TCO can be any suitable conductive material having a low light absorption with respect to a spectrum or range from a visible region to a near infrared region of light incident from the exterior of the photoelectric conversion device 1. For example, the TCO may be a metal oxide having excellent conductivity, such as indium tin oxide (ITO), tin oxide (SnO₂), fluorine-doped tin oxide (FTO), antimony-doped tin oxide (ATO) or zinc oxide (ZnO₂).

In order to enhance photoelectric conversion efficiency, the surface resistance of the first and second electrodes 10 and 10' should be as low as possible.

However, in the first and second substrates 11 and 11', the second electrode 10' formed on a surface of the second substrate 11' opposite to (or facing away from) the first substrate 11 is not essential. In a case where the second electrode 10' is formed on the surface of the second substrate 11', it is not necessarily transparent. That is, the second electrode 10' does not necessarily have a low absorption with respect to a spectrum or range from a visible region to a near infrared region of light incident from the exterior of the photoelectric conversion device 1.

Also, detailed description of the first or second electrode 10 or 10' according to this embodiment will be described later in more detail.

In the photoelectric conversion device 1, the photoelectrode layer 3 is used as an inorganic metal oxide semiconductor layer having a photoelectric conversion function. The photoelectrode layer 3 is formed as a porous layer.

More specifically, as shown in FIGS. 1 and 2, the photoelectrode layer 3 is formed by stacking a plurality of metal oxide corpuscles (or particles) 31 such as TiO2 on the surface of the first electrode 10. The metal oxide corpuscles 31 stacked as described above constitute a porous body, i.e., a nano-porous layer containing nanometer pores therein.

As described above, the photoelectric layer 3 is formed as a porous body containing a plurality of micro-pores, so that it is possible to increase the surface area of the photoelectrode layer 3 and to connect a large amount of sensitizing dye 33 to the surface of the metal oxide corpuscle 31. Accordingly, the photoelectric conversion device 1 can have high photoelectric conversion efficiency.

In the photoelectrode layer 3, the sensitizing dye 33 is connected to the surface of the metal oxide corpuscle 31 with a linking group 35 interposed therebetween, thereby obtaining the photoelectrode layer in which inorganic metal oxide semiconductors are sensitized.

Also, the term "linking" refers to that the inorganic metal oxide semiconductor and the sensitizing dye are chemically or physically bonded to each other (e.g., bonding by absorption or the like). Therefore, the term "linking group" includes not only a chemical functional group but also an anchoring or adsorbing group.

Although FIG. 2 shows a state in which only one sensitizing dye 33 is connected on the surface of the metal oxide corpuscle 31, it is only a simple schematic view. In order to increase electrical power of the photoelectric conversion device 1, it is preferable that the number of sensitizing dyes 33 connected to the surface of the metal oxide corpuscle 31 is as many as possible, and a large number of sensitizing dyes 33 are coated on the surface of the metal oxide corpuscle 31 as wide as possible.

However, in a case where the number of the coated sensitizing dyes is increased, excited electrons may be recombined by interaction between approaching sensitizing dyes 33, and therefore, these electrons may not be extracted as electric energy.

Hence, a co-adsorption substance such as deoxycholic acid may be used so that the sensitizing dyes 33 can be coated while maintaining an appropriate distance therebetween.

The photoelectrode layer 3 may be formed by stacking the metal oxide corpuscles 31 having a size of about 20 to 100nm as a number-average particle size of a primary particle into a multi-layered structure. The thickness of the photoelectrode layer 3 may be a few µm (preferably, less than 10µm).

If the thickness of the photoelectrode layer 3 is thinner than a few µm, light that transmits the photoelectrode layer 3 is increased, and the light excitation of the sensitizing dyes 33 is insufficient. Therefore, effective photoelectric conversion efficiency may not be obtained.

Also, if the thickness of the photoelectrode layer 3 is thicker than a few µm, the distance between the surface of the photoelectrode layer 3 (the surface that comes in contact with the electrolyte solution 5) and the electrical conducting surface (the interface between the photoelectrode layer 3 and the first electrode 10) is lengthened. Therefore, since it is difficult that excited electrons are effectively transferred to the electrical conducting surface, satisfactory photoelectric conversion efficiency may not be obtained.

Next, the metal oxide corpuscle 31 and the sensitizing dye 33, available for the photoelectrode layer 3 according to an embodiment of the present invention, will be described in more detail.

Generally, the inorganic metal oxide semiconductor has a photoelectric conversion function for light in a partial wavelength region. However, the sensitizing dye 33 is connected to the surface of the metal oxide corpuscle 31, so that photoelectric conversion is possible with respect to light in a spectrum or range from a visible region to a near infrared region.

A compound available for the metal oxide corpuscle 31 is not particularly limited as long as it is a compound that connects the sensitizing dye 33 and has a sensitized photoelectric conversion function. For example, the compound may include titanium oxide, tin oxide, tungsten oxide, zinc oxide, indium oxide, niobium oxide, iron oxide, nickel oxide, cobalt oxide, strontium oxide, tantalum oxide, antimony oxide, lanthanide oxide, yttrium oxide, vanadium oxide, or the like.

Here, since the surface of the metal oxide corpuscle 31 is sensitized by the sensitizing dye 33, the conduction band of the inorganic metal oxide may exist at a position at which it easily receives electrons from the optical excitation trap of the sensitizing dye 33.

In this viewpoint, the compound used as the metal oxide corpuscle 31 may include titanium oxide, tin oxide, zinc oxide, niobium oxide or the like. In the viewpoint of price, environment or the like, the compound used as the metal oxide corpuscle 31 may include titanium oxide.

The sensitizing dye 33 is not particularly limited as long as it is a dye having a photoelectric conversion function with respect to light in a set spectrum or range (e.g., in a spectrum or range from a visible region to a near infrared region). For example, the sensitizing dye 33 may include an azo-based dye, a quinacridone-based dye, a diketopyrrolopyrrole-based dye, a squarylium-based dye, a cyanine-based dye, a merocyanine-based dye, a triphenylmethane-based dye, a xanthene-based dye, a porphyrin-based dye, a chlorophyll-based dye, a ruthenium complex-based dye, an indigo-based dye, a perylene-based dye, a dioxadine-based dye, an anthraquinone-based dye, a phthalocyanine-based dye, a naphthalocyanine-based dye, a derivative thereof, or the like.

The sensitizing dye 33 may include a functional group connectable to the surface of the metal oxide corpuscle 31 as the linking group so that excitation electrons of the optically excited dye can be rapidly transferred to the conduction band of the inorganic metal oxide.

The functional group is not particularly limited as long as it is a substituting group having a function that connects the sensitizing dye 33 to the surface of the metal oxide corpuscle 31 and rapidly transfers the excitation electrons of the dye to the conduction band of the inorganic metal oxide. For example, the functional group may include a carboxyl group, a hydroxyl group, a hydroxamic acid group, a sulfinyl group, a phosphonic acid group, a phosphinic acid group, or the like.

The counter-electrode layer 7 serves as a positive electrode of the photoelectric conversion device 1. The counter-electrode layer 7 is formed as a film on the surface of the second substrate 11' with the second electrode 10' formed thereon, opposing or facing the first substrate 11 with the first electrode 10 formed thereon.

That is, the counter-electrode layer 7 is disposed on the surface of the second electrode 10' to be opposite to the photoelectrode layer 3 in a region surrounded by the first electrode 10, the second electrode 10' and the sealing member 9.

A metal catalyst layer having conductivity is disposed on a surface of the counter-electrode layer 7 (a side of the counter-electrode layer 7, opposite to the photoelectrode layer 3).

For example, the conductive material available for the counter-electrode layer 7 may include metal (platinum, gold, silver, copper, aluminum, rhodium, indium or the like), metal oxide (indium tin oxide (ITO)), tin oxide (including tin oxide doped with fluorine or the like), zinc oxide, conductive carbon material, conductive organic material, or the like.

The thickness of the counter-electrode layer 7 is not particularly limited. For example, the thickness of the counter-electrode layer 7 may be at or between 5 nm and 10 µm.

Also, the extracting wires W are respectively connected to the counter-electrode layer 7 and the first electrode 10 of the side at which the photoelectrode layer 3 is formed. The extracting wire W from the first electrode 10 and the extracting wire W from the counter-electrode layer 7 are connected to each other at the exterior of the photoelectric conversion device 1.

The first electrode 10 and the counter-electrode layer 7 may be isolated from each other so as to be sealed by the sealing member 9 while being spaced apart from each other.

The sealing member 9 is formed along outer circumferential portions of the first electrode 10 and the counter-electrode layer 7. The sealing member 9 may function to seal a space between the first electrode 10 and the counter-electrode layer 7.

A resin having high sealing performance and corrosion resistance may be used as the sealing member 9. For example, the resin may include thermoplastic resin, photocurable resin, ionomer resin, glass frit, or the like, which are formed in a film shape.

Also, the electrolyte solution 5 is injected into the space between the first electrode 10 and the counter-electrode layer 7 and then sealed by the sealing member 9.

For example, the electrolyte solution 5 includes an electrolyte, a medium and an additive.

Here, the electrolyte may include a redox electrolyte such as an I3-/I- or Br3-/Br-series, or the like. For example, the electrolyte may include a mixture of I2 and iodide (LiI, NaI, KI, CsI, MgI₂, CuI, tetraalkylammonium iodide, pyridinium iodide, imidazolium iodide and the like), a mixture of Br₂ and bromide (LiBr and the like), an organic molten salt compound, and the like. However, the substance used as the electrolyte is not limited thereto.

The aforementioned iodide, bromide or the like may be used singly or in combinations thereof.

Particularly, the electrolyte may include a mixture of I₂ and iodide (e.g., I₂ and LiI), and an electrolyte mixed with pyridinium iodide, imidazolium iodide or the like. However, the electrolyte is not limited thereto.

In the electrolyte solution 5, the concentration of the I₂ may be at or between 0.01 and 0.5 M, and any one or both of the iodide and bromide (in the combinations thereof) may be at or between 0.1 to 15 M.

The medium used in the electrolyte solution 5 may be a compound capable of realizing excellent ion conductivity. The medium may include a liquid-phase medium, a solid-phase medium or an ionic liquid.

Various suitable kinds of additives may be added into the electrolyte solution 5 so as to enhance the durability of the photoelectric conversion device 1 or electric power.

The thickness of the layer put and sealed in the electrolyte solution 5 is not particularly limited. However, the layer may be formed to have a thickness in which the counter-electrode layer 7 does not come in direct contact with the photoelectrode layer 3 having the adsorbed dye. Specifically, the thickness of the layer may be at or between 0.1 and 100 µm.

In the photoelectrode layer 3 including the metal oxide corpuscle 31 and the sensitizing dye 33 connected to the surface of the metal oxide corpuscle 31 with the linking group 35 interposed therebetween, light comes in contact with the sensitizing dye 33 connected to the surface of the metal oxide corpuscle 31 as illustrated in FIG. 2. Then, the sensitizing dye 33 is in an excitation state and emits optically excited electrons. The emitted excitation electrons are transferred to the conduction band of the metal oxide corpuscle 31 through the linking group 35.

The excitation electrons that approach the metal oxide corpuscle 31 are transferred to another metal oxide corpuscle 31 to approach the first electrode 10, and flow out to the exterior of the photoelectric conversion device 1 through the extracting wire W.

Also, the sensitizing dye 33 that is in a state in which electrons are deficient due to the emitted excitation electrons receives electrons supplied from the counter-electrode layer 7 through the electrolyte such as I3-/I- in the electrolyte solution 5, and thus, returns to an electrically neutral state.

Hereinafter, the configuration of an electrode for a photoelectric conversion device according to embodiments of the present invention will be described in more detail with reference to FIGS. 1, 3 and 4 to 7.

For convenience, the following description discloses in detail a first electrode 10 and a first substrate 11. However, it should be apparent that in the following description, the first electrode (the electrode) 10 (10') can refer to the first electrode 10 or the second electrode 10' as shown in FIG. 1, and the first substrate (the substrate) 11 (11') can refer to the first substrate 11 or the second substrate 11' as shown in FIG. 1.

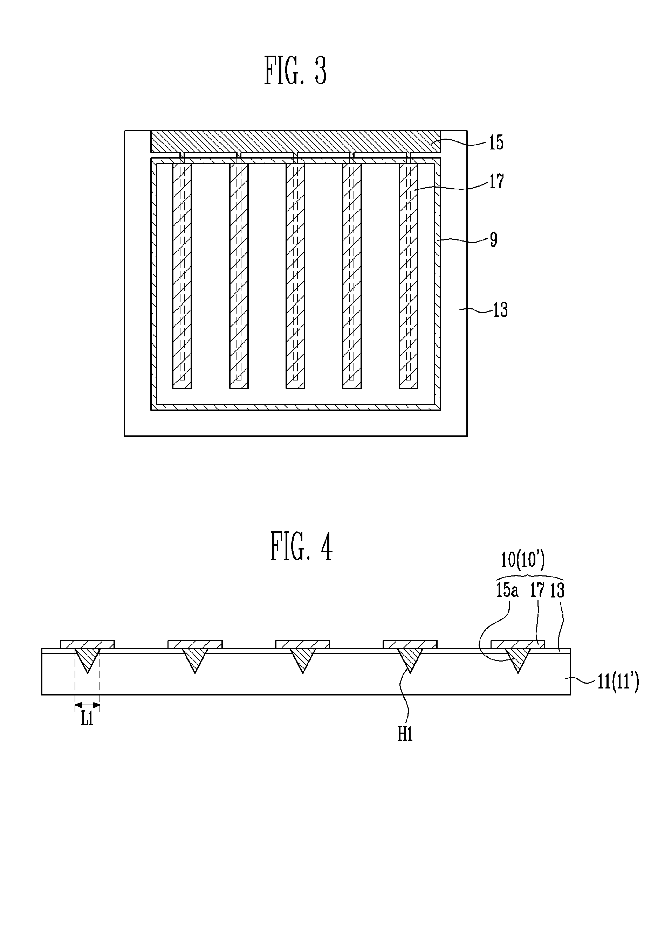

Referring to FIG. 4, a first electrode 10 (or electrode 10') for the photoelectric conversion device 1 according to the first embodiment of the present invention includes a transparent conductive layer 13 that is formed on a first substrate 11 (or substrate 11') and has spacing regions, also referred to as spaces or gaps, L1 formed at a set or predetermined interval; a metal electrode layer 15a formed in a corresponding one of the spacing regions L1; and protection layer 17 that is formed on the transparent conductive layer 13 and the metal electrode layer 15a to cover the metal electrode layer 15a.

Here, groove portions H1 each having a set or predetermined pattern are formed in the first substrate 11, and the positions of the groove portions H1 are formed to correspond to the respective spacing regions L1 formed at the set or predetermined interval in the transparent conductive layer 13. Although the groove portions H1 may be formed using a physical or chemical etching method, the method of forming the groove portions H1 is not limited thereto. For example, an etching method using a laser may be used as the physical etching method, and a method of performing liquid or vapor phase etching after using a photolithography technique may be used as the chemical etching method. Alternatively, a combination of the physical and chemical etching methods may be used as the etching method.

The material of the first substrate 11 can be any suitable transparent material having a low light absorption with respect to a spectrum or range from a visible region to a near infrared region of light (sunlight or the like) incident from the exterior of the photoelectric conversion device 1. Examples of the material available for the first substrate 11 are identical (or substantially identical) to those described above, and therefore, will not be provided again.

The transparent conductive layer 13 is formed on the first substrate 11 and patterned to have the spacing regions L1 at the set or predetermined interval. The transparent conductive layer 13 is formed as a film using a transparent conductive oxide (TOC). The material of the transparent conductive layer 13 is not particularly limited as long as it is a conductive material having a low light absorption with respect to a spectrum or range from a visible region to a near infrared region of light incident from the exterior of the photoelectric conversion device 1. Examples of the material available for the transparent conductive layer 13 are identical (or substantially identical) to those described above, and therefore, will not be provided again.

Referring to FIG. 4, the metal electrode layer 15a is formed to have patterns corresponding to the patterns of the respective groove portions H1 formed in the first substrate. As described above, the positions of the groove portions H1 are formed to match or correspond to the respective spacing regions L1 formed in the transparent conductive layer 13. In one embodiment, the height of an upper or top surface of the metal electrode layer 15a is formed to be between the height of an upper or top surface of the first substrate 11 and the height of an upper or top surface of the transparent conductive layer 13. Preferably, the upper or top surface of the metal electrode layer 15a is formed to have a height identical to the upper or top surface of the transparent conductive layer 13 or to have a height slightly lower than the upper or top surface of the transparent conductive layer 13.

The metal electrode layer 15a functions to transfer excitation electrons to the extracting wire W. Here, the excitation electrons are transferred through the metal oxide corpuscles 31 to approach the first electrode 10. The metal electrode layer 15a is a metal wire formed on the surface of the first electrode 10.

The metal electrode layer 15a is formed to prevent a phenomenon in which the surface resistivity of the first electrode 10 is generally high (about 10Ω/sq or higher), the generated current is converted into Joule heat in a base material having relatively low conductivity, such as the transparent conductive layer 13, and therefore, photoelectric conversion efficiency is lowered.

Accordingly, the metal electrode layer 15a is electrically connected to the first electrode 10. The material of the metal electrode layer 15a may include a high-conductive metal such as Ag, Ag/Pd, Cu, Au, Ni, Ti, Co, Cr or Al, an alloy thereof, a material such as glass frit, or an alloy of the metal.

The shape of the pattern of the metal electrode layer 15a in a plane direction is not particularly limited as long as it reduces the loss of electrical energy. That is, the pattern of the metal electrode layer 15a may be formed in any suitable shape such as a lattice shape, a stripe shape, a rectangular shape, or a comb (teeth) shape.

As described above, the pattern of the metal electrode layer 15a according to the first embodiment of the present invention is formed to match or correspond to the pattern of the respective groove portions H1 formed in the first substrate 11. In this instance, the cross-section of the pattern of the metal electrode layer 15a in the thickness direction of the first substrate 11 has a triangle shape (e.g., a plurality of triangles).

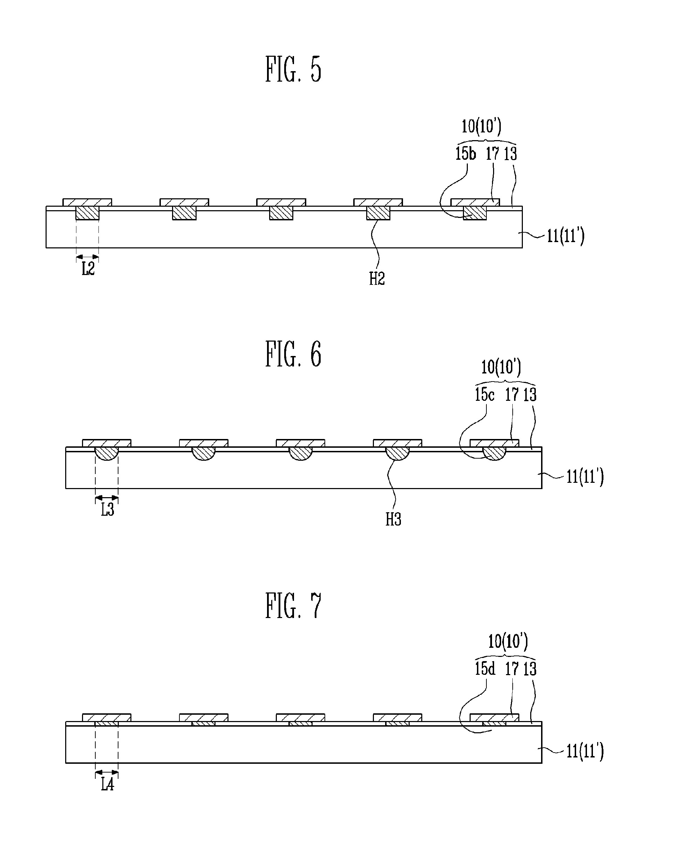

Referring to FIG. 5, the metal electrode layer 15b according to the second embodiment of the present invention is formed to have a pattern matching or corresponding to the pattern of respective groove portions H2 formed in a first substrate 11. As described above, the positions of the groove portions H2 are formed to match or correspond to respective spacing regions L2 formed in a transparent conductive layer 13. In this instance, the cross-section of the pattern of the metal electrode layer 15b in the thickness direction of the first substrate 11 may have a rectangle shape (e.g., a plurality of rectangles) unlike the first embodiment.

As shown in FIG. 6, the metal electrode layer 15c according to the third embodiment of the present invention is formed to have a pattern matching or corresponding to the pattern of respective groove portions H3 formed in a first substrate 11. As described above, the positions of the groove portions H3 are formed to match or correspond to respective spacing regions L3 formed in a transparent conductive layer 13. In this instance, the cross-section of the pattern of the metal electrode layer 15c in the thickness direction of the first substrate 11 may have a circle shape (e.g., a plurality of half-circles) unlike the first and second embodiments. That is, the cross-section of the pattern of the metal electrode layer 15c may have various suitable shapes, such as a polygon shape, a polygonal cone shape, an ellipse shape, or a circle shape.

In one embodiment, the height of each of the metal electrode layers 15a, 15b and 15c according to the first to third embodiments of the present invention is formed to be between the height of an upper surface of the first substrate 11 and the height of an upper surface of the transparent conductive layer 13. Preferably, each of the metal electrode layers 15a, 15b and 15c according to the first to third embodiments of the present invention is formed to have a height identical to the upper surface of the transparent conductive layer 13 or to have a height slightly lower than the upper surface of the transparent conductive layer 13.

As shown in FIG. 7, the metal electrode layer 15d according to the fourth embodiment of the present invention is formed in spacing regions L4 formed at a set or predetermined interval in a transparent conductive layer 13 on a first substrate 11, respectively. That is, the first substrate 11 according to the fourth embodiment of the present invention is not provided with the groove portions H1, H2 and H3 in the first to third embodiments. Accordingly, a lower or bottom surface of the metal electrode layer 15d comes in contact with an upper or top surface of the first substrate 11.

Here, the metal electrode layer 15a is formed of a metal such as Ag, Ag/Pd, Cu, Au, Ni, Ti, Co, Cr or Al, as described above. Hence, the metal electrode layer 15a may be corroded by the electrolyte solution containing iodine (I3-/I- or the like). Accordingly, the photoelectric conversion device 1 according to the embodiment of the present invention includes a protection layer 17 which will be described below in more detail.

The protection layer 17 functions to prevent or restrain corrosion caused by the electrolyte solution 5 of each of the metal electrode layers 15a, 15b, 15c and 15d. The protection layer 17 is positioned on the transparent conductive layer 13 and each of the metal electrode layers 15a, 15b, 15c and 15d to coat the exposed surface of each of the metal electrode layers 15a, 15b, 15c and 15d, thereby protecting each of the metal electrode layers 15a, 15b, 15c and 15d from the corrosion caused by the electrolyte solution 5. Here, the protection layer 17 is obtained by coating and sintering a glass paste with a low melting point on the exposed surface of each of the metal electrode layers 15a, 15b, 15c and 15d. In one embodiment, the protection layer 17 has a thickness at or between 10 and 50 µm. Preferably, the protection layer 17 has a thickness of more than 20 µm so as to prevent a defect such as a pin hole.

If a comparable metal electrode layer is protruded from a substrate, the interface between regions has a very large step difference. In one region, the protruded metal electrode layer is formed, and the protection layer is formed on the metal electrode layer. In another region, only the protruded metal electrode layer is formed, and the protection layer is not formed on the metal electrode layer. Here, the protection layer is not formed on a lower or bottom surface of the sealing member, and the adhesion of the sealing member may be degraded or the sealing member may get loose due to the protruded metal electrode layer itself. Therefore, there is a problem in view of the reliability of products.

However, as described in the first to fourth embodiments, the height of the upper surface of each of the metal electrode layers 15a, 15b, 15c and 15d is formed to be between the height of the upper surface of the first substrate 11 and the height of the upper surface of the transparent conductive layer 13, i.e., to be buried or embedded in the first substrate 11 and/or the transparent conductive layer 13. Accordingly, the aforementioned step difference can be reduced.

Referring to FIG. 3, the protection layer 17 according to an embodiment of the present invention is formed on the exposed surface of the metal electrode layer 15 in the region which has the electrolyte solution 5 injected thereinto and is sealed by the sealing member 9, and is not formed on the exposed surface of the metal electrode layer 15 formed at the outside of the region sealed by the sealing member 9. As the metal electrode layer 15 has a structure in which the step difference is reduced, the leakage of the electrolyte solution 5 due to the degradation of the adhesion of the sealing member or the looseness of the sealing member is reduced, thereby enhancing the reliability of products.

In a case where the metal electrode layer 15 has a rectangular shape, three surfaces of the metal electrode layer 15 were conventionally exposed. On the other hand, if the metal electrode layer 15 according to the embodiment of the present invention is formed to be buried or embedded in the first substrate 11 and/or the transparent conductive layer 13, only the upper surface of the metal electrode layer 15 is exposed. Thus, it is possible to decrease the possibility of corrosion of the metal electrode layer 15, which may be caused by the crack or looseness of the protection layer 17.

The glass paste composite used in the protection layer 17 is a paste composite including glass frit, binder resin, solvent, additive, or the like. The glass paste composite is coated on the metal electrode layer 15 buried or embedded in the first substrate 11 and/or the transparent conductive layer 13 and then sintered, thereby forming the protection layer 17. Here, the glass frit used in the glass paste composite may include at least one of alumina, zirconium oxide, silica, silicate, phosphate, colloidal silica, alkyl silicate, boron oxide, bismuth oxide, zinc oxide and metal alkoxide.

As described above, according to the embodiments of the present invention, the shape of a protruded electrode is improved, so that the reliability of products can be enhanced through a simple process.

Also, as the metal electrode layer has a structure in which the step difference is reduced as described above, the leakage of the electrolyte solution due to the degradation of the adhesion of the sealing member or the looseness of the sealing member can be reduced, thereby enhancing the reliability of products.

Also, while three surfaces of the metal electrode layer were conventionally exposed, only the upper surface of the metal electrode layer is exposed. Thus, it is possible to decrease the possibility of corrosion of the metal electrode layer, which may be caused by the crack or looseness of the protection layer.

While the present invention has been described in connection with certain exemplary embodiments, it is to be understood that the invention is not limited to the disclosed embodiments, but, on the contrary, is intended to cover various modifications and equivalent arrangements included within the scope of the appended claims.

## Claims

1. An electrode for a photoelectric device, the electrode comprising:
a substrate;
a transparent conductive layer on the substrate having a plurality of spacing regions at a set interval;
a metal electrode layer in a corresponding one of the spacing regions; and
a protection layer on the transparent conductive layer and the metal electrode layer to coat the metal electrode layer.

2. The electrode according to claim 1, wherein the substrate has groove portions with a set pattern.

3. The electrode according to claim 2, wherein the positions of the groove portions match the respective spacing regions.

4. The electrode according to claim 2 or 3, wherein the metal electrode layer has a shape matching a corresponding one of the groove portions.

5. The electrode according to claim 2, 3 or 4, wherein the cross-section of each of the groove portions in the thickness direction of the substrate has a polygonal shape, a polygonal cone shape, an elliptic shape, or a circular shape.

6. The electrode according to any one of the preceding claims, wherein a lower surface of the metal electrode layer contacts an upper surface of the substrate.

7. The electrode according to any one of the preceding claims, wherein the height of an upper surface of the metal electrode layer is between the height of the upper surface of the substrate and the height of an upper surface of the transparent conductive layer.

8. The electrode according to any one of the preceding claims, wherein the protection layer has a thickness at or between 10 and 50µm.

9. A method of preparing an electrode for a photoelectric device, the method comprising:
providing a substrate having a transparent conductive layer formed thereon;
patterning the transparent conductive layer to have spacing regions formed at a set interval;
forming a metal electrode layer in a corresponding one of the spacing regions; and
forming a protection layer on the transparent conductive layer and the metal electrode layer to coat the metal electrode layer.

10. The method according to claim 9, further comprising forming groove portions with a set pattern on the substrate before the forming of the metal electrode layer.

11. The method according to claim 10, wherein the positions of the groove portions match the respective spacing regions.

12. The method according to claim 10, wherein the metal electrode layer has a shape matching a corresponding one of the groove portions.

13. The method according to claim 10, wherein the cross-section of each of the groove portions in the thickness direction of the substrate has a polygonal shape, a polygonal cone shape, an elliptic shape, or a circular shape.

14. The method according to any one of claims 9 to 13, wherein, in the forming of the metal electrode layer, a lower surface of the metal electrode layer comes in contact with an upper surface of the substrate.

15. A photoelectric device comprising:
a first substrate;
a first electrode on the first substrate;
a photoelectrode layer on at least one surface of the first electrode, the photoelectrode layer comprising a photo-sensitizing dye;
a second substrate;
a second electrode on the second substrate and facing the first electrode;
a counter-electrode layer on at least one surface of the second electrode, the counter-electrode layer comprising a conductive catalyst;
a sealing member joining the first and second electrodes; and
an electrolyte solution injected into a space between the first and second electrodes and sealed in the space between the first and second electrodes by the sealing member,
wherein at least one of the first and second electrodes comprises an electrode according to any one of claims 1 to 8.
